# EUROPÄISCHE PATENTSCHRIFT

(11) **EP 0 789 984 B1**
(45) Veröffentlichungstag und Bekanntmachung des Hinweises auf die Patenterteilung: **15.07.1998**
(21) Anmeldenummer: 95937858.9
(22) Anmeldetag: 02.11.1995
(51) Int. Cl.: H05K 7/18, A47B 47/00

(54) **RAHMENGESTELL FÜR EINEN SCHALTSCHRANK**
FRAME FOR A SWITCHGEAR CABINET
BAIE POUR ARMOIRE DE DISTRIBUTION

(30) Priorität: 05.11.1994 DE 4439614
(43) Veröffentlichungstag der Anmeldung: 20.08.1997
(73) Patentinhaber: Rittal-Werk Rudolf Loh GmbH & Co. KG, 35745 Herborn (DE)
(72) Erfinder: BENNER, Rolf, D-35745 Herborn (DE)
(74) Vertreter: Fleck, Hermann-Josef, Dr.-Ing.
(86) Internationale Anmeldenummer: EP9504288
(87) Internationale Veröffentlichungsnummer: WO9614730

(56) Entgegenhaltungen:
- EP-A- 0 389 910
- DE-U- 9 209 885

## Beschreibung

Die Erfindung betrifft ein Rahmengestell für einen Schaltschrank, das aus Rahmenschenkeln und Eckverbindern zusammengesetzt ist, wobei die Eckverbinder mit Steckansätzen in Steckaufnahmen der Rahmenschenkel eingeführt und mit den Rahmenschenkeln verbunden sind; (siehe z.B. EP-A-0 389 910).

Bei den bekannten Rahmengestellen werden häufig Hohlprofilabschnitte als Rahmenschenkel verwendet, die eine geschlossene Steckaufnahme für die Steckansätze der Eckverbinder bilden. Dabei kann der Querschnitt der Steckaufnahmen und der Steckansätze quadratisch, rechteckförmig oder dreieckig sein. Die geschlossenen Hohlprofilabschnitte sind jedoch teuer in der Herstellung.

Es sind auch Rahmengestelle bekannt, die aus offenen Rahmenschenkeln zusammengesetzt sind. Die Eckverbindungen des Rahmengestelles erfordern dabei jedoch besonders ausgestaltete Verbindungsteile, wobei zur Verbindung der drei im Bereich einer Ecke aufeinanderstoßender Rahmenschenkel meist mehrere spezielle Teile erforderlich sind. Der Vorteil der einfacheren Herstellung der Rahmenschenkel wird durch den erhöhten Teile- und Montageaufwand für den Zusammenbau des Rahmengestelles erkauft.

Es ist Aufgabe der Erfindung, ein Rahmengestell der eingangs erwähnten Art zu schaffen, bei dem auch mit als offene Hohlprofilabschnitte ausgebildeten Rahmenschenkel Eckverbinder mit Steckansätzen verwendet und damit der Teile- und Montageaufwand klein gehalten werden kann.

Diese Aufgabe wird nach der Erfindung dadurch gelöst, daß die Rahmenschenkel als mehrfach abgebogene, offene Hohlprofilabschnitte ausgebildet sind, die symmetrisch zu ihren Diagonalen und im Bereich ihrer Innenseiten offen sind, daß die Rahmenschenkel im Anschluß an ihre, die senkrecht zueinander stehenden Außenseiten bildenden Profilseiten durch mehrfach nach innen abgebogene Abschnitte Steckaufnahmen für jeweils zwei Steckansätze eines Eckverbinders bilden und daß die so abgebogenen Steckaufnahmen mindestens an zwei, über mehr als 180° verteilten Stellen an den eingeführten Steckansätzen anliegen.

Das offene Hohlprofil wird z.B. allein durch Abkanten mit zwei Steckaufnahmen versehen, in die zwei Steckansätze des Eckverbinders eingeführt werden können. Das Hohlprofil ist symmetrisch zu seiner Diagonale, so daß es in jeder Stellung für jeden Rahmenschenkel des Rahmengestelles verwendet werden kann. Wichtig ist lediglich, daß die abgebogenen Steckaufnahmen mindestens drei Anlagestellen für die Steckansätze bilden, die sich über mehr als 180° des Umfanges der Steckansätze erstrecken. Dann ist sichergestellt, daß der Steckansatz in der Steckaufnahme seitlich unverschiebbar gehalten ist.

Ist nach einer Ausgestaltung vorgesehen, daß die Steckansätze im Querschnitt rund sind, daß die Steckaufnahmen aus drei rechtwinklig nach innen abgekanteten Abschnitten gebildet sind, an die sich ein nach innen abgekanteter Endabschnitt anschließt, daß die parallel zueinander stehenden Abschnitte der Steckaufnahmen an den Durchmesser der runden Steckansätze angepaßt sind, und daß die Endabschnitte eine weitere Anlagestelle für die Steckansätze bilden, dann können Eckverbinder mit Steckansätzen verwendet werden, die von einem handelsüblichen Stabmaterial abgelängt und in Aufnahmen des Eckverbinder-Basisteils eingebracht und darin festgelegt werden.

Ist die Ausgestaltung so, daß die Steckansätze quadratischen Querschnitt aufweisen, und daß die Steckaufnahmen aus vier rechtwinklig nach innen abgekanteten Abschnitten bestehen, wobei die Endabschnitte die Steckaufnahmen nicht schließen, dann lassen sich die gleichen Vorteile erreichen.

Eine Befestigungsmöglichkeit über die gesamte Länge der Rahmenschenkel wird dadurch geschaffen, daß die parallel zu den die senkrecht zueinander stehenden Außenseiten bildenden Profilseiten verlaufenden inneren Abschnitte der Steckaufnahmen mit Reihen von Befestigungsaufnahmen versehen sind.

Ist vorgesehen, daß die die senkrecht zueinander stehenden Außenseiten bildenden Profilabschnitte im Bereich der Steckaufnahmen nach innen versetzte Abschnitte einer Aufnahme für ein Dichtungselement aufweisen und daß die nach innen versetzten Abschnitte Teil der Steckaufnahmen sind, dann können am Rahmenschenkel Dichtungselemente angebracht werden, ohne daß dadurch die Bildung der Steckaufnahmen beeinträchtigt wird.

Für die Festlegung der Steckansätze in den Steckaufnahmen ist nach einer Ausgestaltung vorgesehen, daß die Steckansätze mittels Paß- und/oder Preßsitz in den Steckaufnahmen der Rahmenschenkel gehalten sind.

Der Halt kann dadurch noch verbessert werden, daß die Steckansätze zusätzlich mit den Rahmenschenkeln verschraubt sind, wobei Bohrungen in den Rahmenschenkeln verwendet werden können.

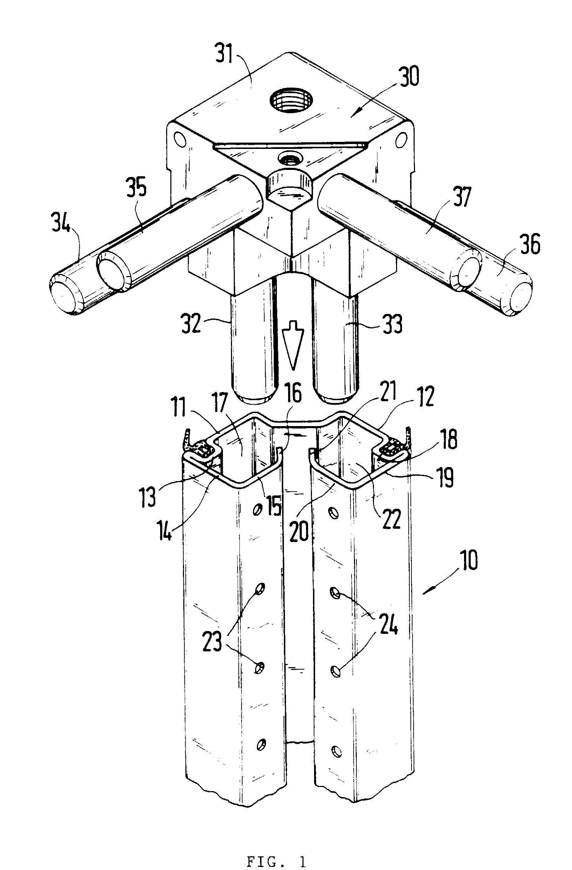

Die Erfindung wird anhand eines in der Zeichnung in Explosionsdarstellung gezeigten Ausführungsbeispiels näher erläutert.

Wie die Zeichnung erkennen läßt, ist nur eine Verbindung zwischen einem Eckverbinder 30 und einem Rahmenschenkel 10 dargestellt. Der Rahmenschenkel 10 wird nach dem Einbringen der Reihen von Bohrungen 23 und 24 in einen Blechstreifen entsprechender Breite z.B. durch Abkanten hergestellt. Die Profilseiten 11 und 12 bilden die senkrecht zueinander stehenden Außenseiten des Rahmenschenkels 10. Die Außenkante ist abgeschrägt und die Profilseiten 11 und 12 sind nach innen abgekantet, um Aufnahmenuten für Dichtungselemente zu bilden. Die Abschnitte 13 und 18 dieser Aufnahmenuten bilden Abschnitte der Steckaufnahmen 17 und 22. Die Steckaufnahmen 17 und 22 werden durch die jeweils nach innen abgekanteten Abschnitte 14, 15 und 16 bzw. 19, 20 und 21 vervollständigt. Der Abstand der Abschnitte 13 und 15 bzw. 18 und 20 ist auf den Durchmesser der runden Steckansätze 32 bis 37 an dem Basisteil 31 des Eckverbinders 30 abgestimmt. Die Endabschnitte 16 und 21 sind so weit eingebogen, daß sie eine weitere, vierte Anlagestelle für die runden Steckansätze 32 bis 37 bilden. Jeder der beiden Steckansätze 32 und 33 liegt daher an allen vier Abschnitten 13 bis 16 bzw. 18 bis 21 der Steckaufnahmen 17 bzw. 22 an. Diese vier Anlagestellen sind über mehr als 180° des Umfanges der Steckansätze 32 bzw. 33 verteilt, so daß diese seitlich eindeutig fixiert sind.

Sind die Endabschnitte 16 und 21 rechtwinklig eingebogen, dann lassen sich auch quadratische bzw. rechteckförmige Steckansätze in den Steckaufnahmen festlegen.

Die parallel zu den Profilseiten 11 und 12 verlaufenden Abschnitte 15 und 20 der Steckaufnahmen 17 und 22 sind mit Reihen von Bohrungen 23 und 24 versehen, um über die gesamte Länge des Rahmenschenkels 10 Befestigungsmöglichkeiten zu schaffen.

Der Rahmenschenkel 10 ist im Bereich der Innenseite offen und symmetrisch zu seiner Diagonale ausgebildet, so daß er an jeder Stelle des Rahmengestelles eingesetzt werden kann. Dabei braucht nur die Ausrichtung der Profilseiten 11 und 12 beachtet zu werden.

Der Eckverbinder 30 besteht aus einem Basisteil 31, das auf drei Seiten jeweils zwei Steckansätze 32,33 bzw. 34,35 bzw. 36,37 trägt, um die im Eckbereich eines Rahmengestelles senkrecht aufeinanderstoßenden, drei Rahmenschenkel 10 miteinander zu verbinden. Die Anordnung der Steckansätze 32 bis 37 ist dabei so, daß ein Anschluß der Rahmenschenkel 10 nur in der richtigen Ausrichtung mit nach außen gerichteten Profilseiten 11 und 12 möglich ist. Die Paare von Steckansätzen sind im Abstand auf den Abstand der Steckaufnahmen 17 und 22 im Rahmenschenkel 10 abgestimmt.

Der Querschnitt der Steckansätze kann beliebig sein, wenn nur beachtet wird, daß die abgekanteten Abschnitte des Rahmenschenkels eine Steckaufnahme bilden, die mindestens drei Anlagestellen für den Steckansatz aufweist, welche um mehr als 180° über den Umfang des Steckansatzes verteilt sind.

Die Steckansätze 32 bis 37 lassen sich auch von handelsüblichen Stabelementen ablängen und in Aufnahmen im Basisteil 31 des Eckverbinders einbringen. Dabei kann die Länge der Steckansätze 32 bis 37 variabel gewählt und an die gewünschte Verwindungssteifigkeit des Rahmengestelles angepaßt werden.

## Patentansprüche

1. Rahmengestell für einen Schaltschrank, das aus Rahmenschenkeln und Eckverbindern zusammengesetzt ist, wobei die Eckverbinder mit Steckansätzen in Steckaufnahmen der Rahmenschenkel eingeführt und mit den Rahmenschenkeln verbunden sind,
dadurch gekennzeichnet,
daß die Rahmenschenkel (10) als mehrfach abgebogene, offene Hohlprofilabschnitte ausgebildet sind, die symmetrisch zu ihren Diagonalen und im Bereich ihrer Innenseiten offen sind,
daß die Rahmenschenkel (10) im Anschluß an ihre, die senkrecht zueinander stehenden Außenseiten bildenden Profilseiten (11, 12) durch mehrfach nach innen abgebogene Abschnitte (13, 14, 15, 16, bzw. 18, 19, 20, 21) Steckaufnahmen (17, 22) für jeweils zwei Steckansätze (32, 33; 34, 35; 36, 37) eines Eckverbinders (10) bilden und
daß die so abgebogenen Steckaufnahmen (17, 22) mindestens an zwei, über mehr als 180° verteilten Stellen an den eingeführten Steckansätzen (32, 33; 34, 35; 36, 37) anliegen.

2. Rahmengestell nach Anspruch 1,
dadurch gekennzeichnet,
daß die Steckansätze (32,33; 34,35; 36,37) im Querschnitt rund sind,
daß die Steckaufnahmen (17,22) aus drei rechtwinklig nach innen abgekanteten Abschnitten (13,14,15; 18,19,20) gebildet sind, an die sich ein nach innen abgekanteter Endabschnitt (16,21) anschließt,
daß die parallel zueinander stehenden Abschnitte (13,15; 18,20) der Steckaufnahmen (17,22) an den Durchmesser der runden Steckansätze (32 bis 37) angepaßt sind, und
daß die Endabschnitte (16,21) eine weitere Anlagestelle für die Steckansätze (32 bis 37) bilden.

3. Rahmengestell nach Anspruch 1,
dadurch gekennzeichnet,
daß die Steckansätze (32 bis 37) quadratischen Querschnitt aufweisen, und
daß die Steckaufnahmen (17,22) aus vier rechtwinklig nach innen abgebogenen Abschnitten (13 bis 16; 18 bis 21) bestehen, wobei die Endabschnitte (16,21) die Steckaufnahmen (17,22) nicht schließen.

4. Rahmengestell nach einem der Ansprüche 1 bis 3,
dadurch gekennzeichnet,
daß die parallel zu den die senkrecht zueinander stehenden Außenseiten bildenden Profilseiten (11,12) verlaufenden inneren Abschnitte (15,20) der Steckaufnahmen (17,22) mit Reihen von Befestigungsaufnahmen (23,24) versehen sind.

5. Rahmengestell nach einem der Ansprüche 1 bis 4,
dadurch gekennzeichnet,
daß die die senkrecht zueinander stehenden Außenseiten bildenden Profilabschnitte (11,12) im Bereich der Steckaufnahmen (17,22) nach innen versetzte Abschnitte (13,18) einer Aufnahme für ein Dichtungselement aufweisen und
daß die nach innen versetzten Abschnitte (13,18) Teil der Steckaufnahmen (17,22) sind.

6. Rahmengestell nach einem der Ansprüche 1 bis 5,
dadurch gekennzeichnet,
daß die Steckansätze (32 bis 37) mittels Paß- und/oder Preßsitz in den Steckaufnahmen (17,22) der Rahmenschenkel (10) gehalten sind.

7. Rahmengestell nach Anspruch 6,
dadurch gekennzeichnet,
daß die Steckansätze (32 bis 37) zusätzlich mit den Rahmenschenkeln (10) verschraubt sind.

## Claims

1. Framework for a switchgear cabinet, which comprises frame members and corner joints, the corner joints which are provided with insertable projections being introduced into socket receivers of the frame members and being connected to the frame members, characterised in that the frame members (10) are configured as multiply bent, open hollow section portions which are symmetrical relative to their diagonal and are open in the region of their internal surfaces, in that the frame members (10), adjacent their section sides (11,12) forming the external surfaces which extend perpendicular to one another, form socket receivers (17,22) for every two insertable projections (32,33; 34,35; 36,37) of a corner joint (30) by means of multiply inwardly bent portions (13,14,15,16, or respectively 18,19,20,21), and in that the socket receivers (17,22), which are thus bent, abut against the introduced insertable projections (32,33; 34,35; 36,37) at at least two locations, which are distributed over more than 180°.

2. Framework according to claim 1, characterised in that the insertable projections (32,33; 34,35; 36,37) have a circular cross-section, in that the socket receivers (17,22) are formed from three portions (13,14,15; 18,19,20), which are bent inwardly at right angles and communicate with an inwardly bent end portion (16,21), in that the portions (13,15; 18,20) of the socket receivers (17,22) extending parallel to one another are adapted to the diameter of the circular insertable projections (32 to 37), and in that the end portions (16,21) form an additional abutment location for the insertable projections (32 to 37).

3. Framework according to claim 1, characterised in that the insertable projections (32 to 37) have a square cross-section, and in that the socket receivers (17,22) comprise four portions (13 to 16; 18 to 21), which are bent inwardly at right angles, the end portions (16,21) not closing the socket receivers (17,22).

4. Framework according to one of claims 1 to 3, characterised in that the inner portions (15,20) of the socket receivers (17,22) are provided with rows of fastening holes (23,24), said portions extending parallel to the section sides (11,12) which form the external surfaces extending perpendicular to one another.

5. Framework according to one of claims 1 to 4, characterised in that the section portions (11,12), which form the external surfaces extending perpendicular to one another, have inwardly offset portions (13,18) of a receiver for a sealing member in the region of the socket receivers (17,22), and in that the inwardly offset portions (13,18) are part of the socket receivers (17,22).

6. Framework according to one of claims 1 to 5, characterised in that the insertable projections (32 to 37) are retained in the socket receivers (17,22) of the frame members (10) by means of a snug fit and/or press fit.

7. Framework according to claim 6, characterised in that the insertable projections (32 to 37) are additionally screw-connected to the frame members (10).

## Revendications

1. Structure de cadre pour armoire de distribution, composée de branches de cadre et de cornières de jonction, où les cornières de jonction sont, par des embouts d'enfichage, enfichées dans des récepteurs d'enfichage des branches de cadre et sont reliées aux branches de cadre,
caractérisée
en ce que les branches de cadre (10) ont la forme de tronçons de profilé creux à plusieurs cintrages et ouverts, qui sont ouvertes symétriquement à leurs diagonales et dans la région de leurs côtés intérieurs,
en ce que les branches de cadre (10), en raccordement à leurs côtés de profilé (11, 12) constituant les côtés extérieurs mutuellement perpendiculaires donnent naissance, grâce à plusieurs tronçons (13, 14, 15, 16 ou 18, 19, 20, 21) cintrés vers l'intérieur, à des récepteurs d'enfichage (17, 22) pour des paires d'embouts d'enfichage (32,33; 34, 35; 36, 37) d'une cornière de jonction (30) et
en ce que les récepteurs d'enfichage (17, 22) ainsi créés par cintrage s'appliquent en au moins deux endroits, écartés de plus de 180°, contre les embouts d'enfichage (32, 33; 34, 35; 36, 37) enfichés.

2. Structure de cadre suivant la revendication 1,
caractérisée
en ce que les embouts d'enfichage (32, 33; 34, 35; 36, 37) sont à section transversale circulaire,
en ce que les récepteurs d'enfichage (17, 22) sont constitués de trois tronçons ( 13, 14, 15; 18, 19, 20) coudés à angle droit vers l'intérieur, auxquels se raccorde un tronçon terminale (16, 21) coudé vers l'intérieur,
en ce que les tronçons mutuellement parallèles (13, 15; 18, 20) des récepteurs d'enfichage (17, 22) sont adaptés au diamètre des embouts d'enfichage circulaires (32 à 37), et en ce que les tronçons terminaux (16, 21) constituent un point d'application supplémentaire pour les embouts d'enfichage (32 à 37).

3. Structure de cadre suivant la revendication 1,
caractérisée
en ce que les embouts d'enfichage (32 à 37) ont une section transversale quadrangulaire, et
en ce que les récepteurs d'enfichage (17, 22) sont constitués de quatre tronçons (13 à 16; 18 à 21) coudés à angle droit vers l'intérieur, où les tronçons terminaux (16, 21) ne clôturent pas les récepteurs d'enfichage (17, 22).

4. Structure de cadre suivant l'une quelconque des revendications de 1 à 3,
caractérisée
en ce que les tronçons intérieurs (15, 20) des récepteurs d'enfichage (17, 22), tronçons orientés parallèlement aux côtés de profilé (11, 12) constituant les côtés extérieurs mutuellement perpendiculaires, présentent des rangées de logements de fixation (23, 24).

5. Structure de cadre suivant l'une quelconque des revendications de 1 à 4,
caractérisée
en ce que les tronçons de profilé constituant les côtés extérieurs mutuellement perpendiculaires présentent, dans la région des récepteurs d'enfichage (17, 22), des tronçons décalés vers l'intérieur (13, 18) d'un logement pour un élément d'étanchéité, et
en ce que les tronçons décalés vers l'intérieur (13, 18) font partie intégrante des récepteurs d'enfichage (17, 22).

6. Structure de cadre suivant l'une quelconque des revendications de 1 à 5,
caractérisée
en ce que les embouts d'enfichage (32 à 37) sont maintenus par siège ajusté et/ou siège pressé dans les récepteurs d'enfichage (17, 22) des branches de cadre (10).

7. Structure de cadre suivant la revendication 6,
caractérisé
en ce que les embouts d'enfichage (32 à 37) sont en complément fixés par vissage aux branches de cadre.
